# NEUE EUROPÄISCHE PATENTSCHRIFT

(11) **EP 2 577 184 B2**
(45) Veröffentlichungstag und Bekanntmachung des Hinweises auf die Entscheidung über den Einspruch: **15.06.2022**
(45) Hinweis auf die Patenterteilung: 01.08.2018
(21) Anmeldenummer: 11781428.5
(22) Anmeldetag: 19.05.2011
(51) Int. Cl.: F24S 25/00

(54) **BEFESTIGUNG EINER TRAGSCHIENE FÜR EIN PV-MODUL AUF EINEM TRAPEZBLECH**
FASTENING OF A SUPPORT RAIL FOR A PV MODULE TO A TRAPEZOIDAL SHEET
FIXATION D'UN RAIL PORTEUR POUR UN MODULE PHOTOVOLTAÏQUE SUR UNE TÔLE TRAPÉZOÏDALE

(30) Priorität: 27.05.2010 DE 102010021713
(43) Veröffentlichungstag der Anmeldung: 10.04.2013
(73) Patentinhaber: Schletter International B.V., 1101 Amsterdam (NL)
(72) Erfinder: URBAN, Hans, 83527 Haag (DE); FLUHRER, Dieter, 84437 Reichertsheim (DE)
(74) Vertreter: Thum, Bernhard
(86) Internationale Anmeldenummer: PCT/DE2011/001084
(87) Internationale Veröffentlichungsnummer: WO 2011/147404

(56) Entgegenhaltungen:
- WO-A1-99/10609
- WO-A1-2009/020177
- DE-A1- 10 113 218
- DE-A1-102007 018 212
- DE-A1-102011 084 556
- DE-U1-202005 003 717
- DE-U1-202009 003 124
- DE-U1-202009 005 741
- DE-U1-202009 010 984
- DE-U1-202009 012 507
- JP-A- H1 113 238
- JP-A- H09 235 844
- US-B2- 7 237 368
- US-B2- 7 814 710

## Beschreibung

Die Erfindung betrifft eine Befestigung einer Tragschiene für ein Photovoltaik-Modul an einer trapezförmigen Rippe eines Trapezblechs.

Aus DE 20 2008 007 838 U1 ist eine Schräganordnung von PV-Modulen auf einem Trapezblech bekannt. Die Schräganordnung umfasst mehrere Halteelemente zum zentralen Aufsetzen auf die Rippen des Trapezblechs sowie zwei quer zu den Rippen gerichtete Tragschienen für PV-Module. Die Halteelemente umgreifen die Rippen dreiseitig und sind an jeweils beiden schrägen Seiten der Rippen befestigt. Die Tragschienen liegen auf den Halteelementen auf und sind mit diesen aufwändig zu verschrauben. Außerdem werden die Halteelemente für verschieden geformte Rippen individuell angefertigt.

Aus DE 20 2009 002 208 U1 ist eine ähnliche Schräganordnung bekannt mit Haltern, die in DE 10 2008 028 108 A1 näher offenbart und wie vorstehend zum zentralen Aufsetzen auf die Rippen eines Trapezblechs vorgesehen sind. Die Halter tragen angeschweißte Gewindezapfen für mehrteilige Klemmeinrichtungen, in welche wiederum die Tragschienen aufgenommen sind. Zum Betätigen der Klemmeinrichtungen ist ein Schraubwerkzeug erforderlich. Auch diese Halter sind für verschiedene Rippenformen individuell anzufertigen. DE202009003124U1 offenbart eine Befestigung einer Tragschiene für ein Photovoltaik-Modul an einer trapezförmigen Rippe eines Trapezblechs, mit dem Merkmale des Oberbegriffs des Anspruchs 1. Aufgabe der Erfindung ist es, eine materialeffiziente, fertigungsgerechte und montagefreundliche Befestigung einer Tragschiene für ein PV-Modul an einer Rippe eines Trapezblechs zu schaffen.

Die Aufgabe wird mit einer Befestigung mit den Merkmalen des Patentanspruchs 1 gelöst. Demgemäß ist vorgesehen, dass die Tragschiene eine hinterschnittene Nut mit einer Nutöffnung enthält und die Tragschiene quer zu der Rippe gerichtet ist. Die Befestigung umfasst außerdem mindestens ein Halteelement. Dieses weist einen Befestigungsabschnitt auf, der an einer schrägen Seite der Rippe befestigt ist. Charakteristisch ist, dass das Halteelement entweder links oder aber rechts an der Rippe angeordnet ist. Der Befestigungsabschnitt kann hierfür flach und plattenförmig gestaltet sein. Außerdem weist das Halteelement einen Eingriffsfortsatz auf, der an dem Befestigungsabschnitt unlösbar angeordnet ist. Zudem ist vorgesehen, dass der Eingriffsfortsatz die Nut in einer Eingriffsstellung hintergreift und in einer dazu gedrehten Losstellung durch die Nutöffnung in die Nut einsetzbar ist. Außerdem ist die Tragschiene mittels des Eingriffsfortsatzes gegen die Oberseite der Rippe niedergehalten, vorzugsweise klemmend.

Die Verbindung zwischen dem Halteelement und der Tragschiene ist schraubenfrei und kann mittels des Eingriffsfortsatzes schnell, einfach, sicher und stabil hergestellt werden. Es ist möglich, das Halteelement montagefreundlich an einer beliebigen Stelle längs der Nutöffnung in die Nut einzusetzen. Dadurch kann das Halteelement auch im Falle einer bereits auf mehreren Rippen angeordneten Tragschiene an jeder freien schrägen Seite dieser Rippen nachträglich montiert werden. Von Vorteil ist weiter, dass die Tragschiene statisch günstig direkt oder lediglich durch dünne eine elastische Schutzrauflage getrennt auf der Oberseite der Rippe aufliegen kann. Zudem ist das Halteelement besonders materialsparend und geometrisch einfach ausführbar, da es entweder nur links oder aber nur rechts angeordnet ist. Es berührt die Oberseite der Rippe nicht. Wesentlich ist außerdem, dass sich das Halteelement anpassungsfrei für verschiedene Rippenformen eignet.

Vorzugsweise ist die Nut beidseitig hinterschnitten. So kann das Halteelement mit dem Eingriffsfortsatz die Nut beidseitig hintergreifen, wofür es zweckmäßig ist, wenn der Eingriffsfortsatz zwei gegengleich nach außen gerichtete Vorsprünge aufweist. Auf diese Art wirkt der Eingriffsfortsatz wie ein Hammerkopf- oder T-förmiger Bolzen mit der Nut zusammen, sodass die Verbindung zwischen dem Halteelement und der Tragschiene besonders stabil ist.

Zum Abtragen besonders großer Lasten parallel zur Tragschiene kann es zweckmäßig sein, wenn der Eingriffsfortsatz einen Zapfen beziehungsweise selbst einen Fortsatz aufweist, der in eine punktuelle Vertiefung im Nutgrund der Nut eingreift. Auf diese Art ist die Tragschiene zusätzlich in ihrer Längsrichtung am Halteelement festgelegt. Die punktuelle Vertiefung kann ein einfaches Bohrloch im Nutgrund sein.

In einer besonders fertigungsgerechten Ausführungsform sind der Eingriffsfortsatz und der Befestigungsabschnitt integral miteinander verbunden und/oder aus genau einem Stück Blech oder Kunststoff gefertigt. Als Fertigungsverfahren eignen sich unter anderem Stanzen oder Laserschneiden,

Besonders in Kombination mit der vorgenannten Ausführungsform kann es weiter von Vorteil sein, wenn der Eingriffsfortsatz und der Befestigungsabschnitt komplanar, insbesondere als planparallele Platte ausgeführt sind. Ein derartiges Halteelement lässt sich besonders einfach fertigen. Alternativ ist es denkbar, dass der Eingriffsfortsatz zum Befestigungsabschnitt dergestalt winklig angestellt ist, dass der Eingriffsfortsatz bezüglich der Oberseite der Rippe steiler gerichtet ist als eine gedachte gerade Verlängerung der schrägen Seite der Rippe. Das heißt, ein Winkel zwischen dem Eingriffsfortsatz und der Oberseite der Rippe ist betragsmäßig einem Rechten Winkel näher als ein Winkel zwischen der gedachten geraden Verlängerung der schrägen Seite und der Oberseite der Rippe. Dies kann die Festigkeit der Verbindung zwischen dem Halteelement und der Tragschiene steigern und das Einsetzen des Eingriffsfortsatzes in die Nut erleichtern, insbesondere falls die Tragschiene bereits auf der Oberseite angeordnet und die Rippe vergleichsweise niedrig ist. Für eine maximale Festigkeit ist der Eingriffsfortsatz vorzugsweise senkrecht oder im Wesentlichen senkrecht zur Oberseite der Rippe gerichtet.

Der Befestigungsabschnitt kann in an sich bekannter Weise mittels Schrauben oder Nieten an der schrägen Seite der Rippe befestigt sein. Um ein vorheriges Einbringen von Löchern in die schräge Seite zu vermeiden, werden hierfür selbstschneidende Schrauben bevorzugt. In dem Befestigungsabschnitt können vorab eingebrachte Durchführöffnungen hingegen von Vorteil sein.

In einer besonders montagefreundlichen Ausführungsform ist vorgesehen, dass der Befestigungsabschnitt entlang der Rippe beidseitig neben der Tragschiene hervorsteht. Demnach ist das Befestigungselement in einer senkrechten Draufsicht auf das Trapezblech links und rechts der Tragschiene zugänglich. So kann ein Monteur etwaige Befestigungsmittel, insbesondere die vorgenannten Schrauben oder Nieten, in ergonomischer Weise mittels eines Werkzeugs, beispielsweise einem Schraubendreher oder einem elektrischen Schraubgerät, an dem Befestigungsabschnitt ansetzen.

In einer weiteren vorteilhaften Ausführungsform ist zwischen dem Befestigungsabschnitt und der schrägen Seite der Rippe ein elastisches und/oder plastisches Abstandsmittel angeordnet, das endmontiert bevorzugt komprimiert ist. Aufgrund der elastischen und/oder plastischen Eigenschaft des Abstandsmittels kann sich dessen Abstandsmaß in vorteilhafter Weise mittels Befestigung des Befestigungsabschnitts verringern. Das Abstandsmittel kann zu diesem Zweck aus einem gummiartigen Material bestehen, insbesondere aus einem EPDM-Material oder einem vergleichbaren Elastomere mit einer bevorzugten Shore-Härte zwischen 50 und 80. Ein solches Abstandsmittel kann vorgefertigt an dem Befestigungsabschnitt befestigt sein, sodass es von einem Monteur nicht eigens anzuordnen ist. Es kann beispielsweise mittels Klebestoff befestigt sein oder alternativ mittels Haltsnoppen, die in Öffnungen im Befestigungsabschnitt eingedrückt sind. Das Abstandsmittel kann bevorzugt als eine im Wesentlichen einteilige Schicht ausgeführt sein oder auch aus mehreren lokalen Körpern bestehen. Insbesondere in Kombination mit einer Befestigung des Befestigungsabschnitts mittels Schrauben oder Nieten kann es vorteilhaft sein, wenn das Abstandsmittel zugleich ein Dichtmittel ist, das ein Eindringen von Regenwasser durch Öffnungen in der schrägen Seite der Rippe verhindert.

Während der Befestigung des Befestigungsabschnitts an der schrägen Seite der Rippe kann das elastisch und/oder plastische Abstandsmittel komprimiert werden, wodurch sich das Halteelement näher zur schrägen Seite bewegt und dabei aufgrund seiner Neigung zugleich eine geringe Bewegungskomponente nach unten erfährt. Nach unten bedeutet in diesem Zusammenhang in eine Richtung nach unten, die senkrecht zur Oberseite der Rippe ist. Dabei ist von besonderem Vorteil, dass das Halteelement mittels des Eingriffsfortsatzes die Tragschiene in zunehmenden Maße gegen die Oberseite klemmt, sodass eine besonders stabile, sichere und dauerhafte Verbindung entsteht. In einer denkbaren Alternative können etwaige Schrauben oder Nieten bewusst nicht senkrecht zur schrägen Seite, sondern etwas steiler angesetzt werden, sodass sich diese beim Verspannen senkrecht richten und auf diese Weise der Befestigungsabschnitt eine zusätzliche geringe Bewegungskomponente nach unten erfährt.

In der Praxis wird das Trapezblech weitere trapezförmige Rippen aufweisen und die Tragschiene mehrere der Rippen queren. Zur weiteren Befestigung der Tragschiene ist es dabei zweckmäßig, wenn mindestens ein weiteres Halteelement wie zuvor vorgesehen ist, mit dem die Tragschiene gegen die Oberseite von mindestens einer der weiteren Rippen niedergehalten ist.

In einer hinsichtlich der Tragschiene besonders materialeffizienten Ausführungsform quert die Tragschiene lediglich drei oder zwei der Rippen. Außerdem ist lediglich ein weiteres Halteelement vorgesehen, mit dem die Tragschiene gegen die Oberseite von genau einer weiteren der drei oder zwei Rippen niedergehalten ist. Dabei ist es statisch vorteilhaft, wenn die Halteelemente an den zwei äußeren schrägen Seiten der drei oder zwei Rippen befestigt sind. Eine solche Befestigung, bei der die Tragschiene lediglich drei oder zwei Rippen quert eignet sich besonders als punktuelle Befestigungsbasis für die Kante eines PV-Moduls oder den benachbarten Kanten zweier nebeneinander angeordneter PV-Module.

Für die Anbringung eines PV-Moduls ist in der Tragschiene vorzugsweise eine zweite hinterschnittene Nut enthalten. Diese zweite Nut kann insbesondere an der Oberseite der Tragschiene vorgesehen sein.

Die Erfindung betrifft schließlich auch eine Mehrfachanordnung, bei der eine weitere Befestigung vorgesehen ist oder drei weitere Befestigungen vorgesehen sind, wobei auf den Tragschienen der Befestigungen ein PV-Modul angebracht ist. Die Tragschienen einer Zweifachanordnung können mehrere PV-Module in einer Reihe tragen. Die Tragschienen einer Vierfachanordnung sind bevorzugt in einem rechteckigen Raster angeordnet, wobei von Vorteil ist, wenn benachbarte PV-Module mit ihren Kante zugleich auf jeweils zwei der Tragschienen angebracht sind. So können die Tragschienen besonders kurz ausgeführt sein und außerdem jeweils unter dem PV-Modul enden.

Nachfolgend wird die Erfindung anhand mehrerer Ausführungsbeispiele näher erläutert. Es zeigt:
**Fig. 1** eine Befestigung einer Tragschienen für ein PV-Modul an einer trapezförmigen Rippe eines Trapezblechs
**Fig. 2** ein Halteelement der Befestigung gemäß **Fig. 1** separat
**Fig. 3** einen Halbschnitt der Befestigung gemäß **Fig. 1** von vorne (Schnitt AA in **Fig. 4**)
**Fig. 4** eine Seitenansicht der Befestigung gemäß **Fig. 1** von links
**Fig. 5** Schritte des Fügens der Tragschiene mit einem Halteelement gemäß **Fig. 1**
**Fig. 6** einen Vormontagezustand des Halteelements gemäß **Fig. 1**
**Fig. 7** einen Endmontagezustand des Halteelements gemäß **Fig. 1**
**Fig. 8** ein weiteres Halteelement im Vormontagezustand
**Fig. 9** ein Halteelement der Befestigung separat
**Fig. 10** einen Endmontagezustand mit dem Halteelement gemäß **Fig. 9**
**Fig. 11** einer Mehrfachanordnung mit dem Detail gemäß **Fig. 1**
**Fig. 12** eine weitere Mehrfachanordnung

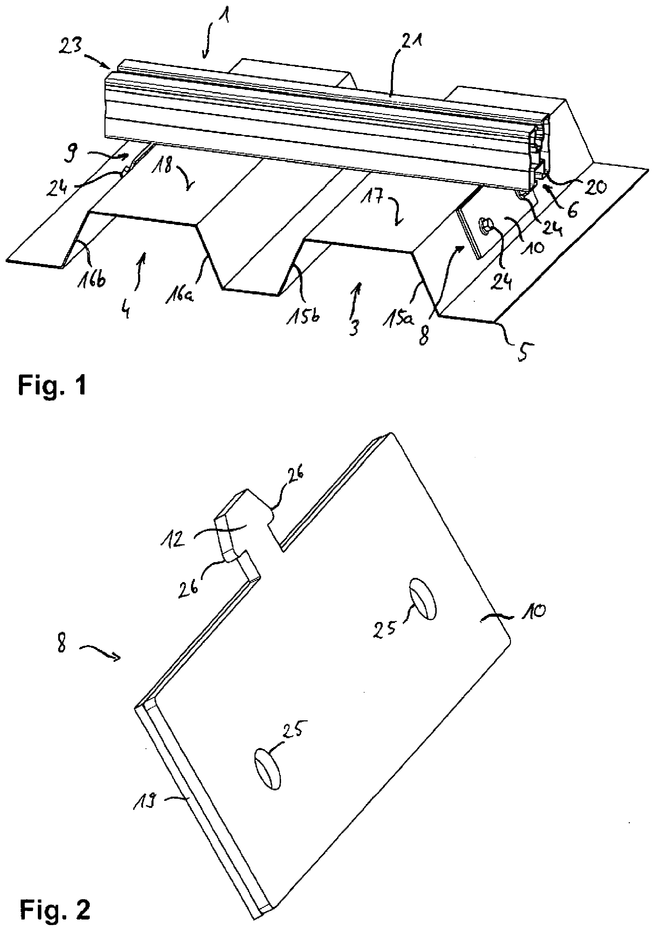

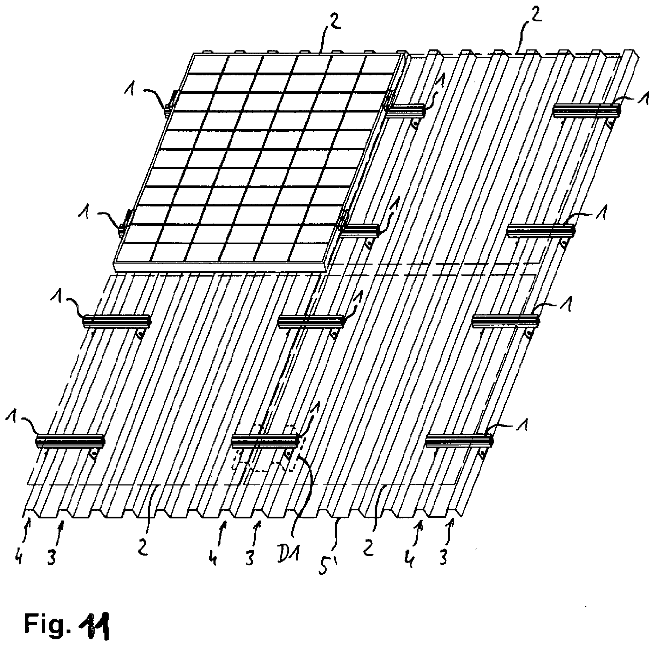

**Fig. 1****,** **Fig. 3** und **Fig. 4** zeigen eine Befestigung einer Tragschiene **1** an zwei trapezförmigen Rippen **3, 4** eines Trapezblechs **5.** Die Befestigung entspricht dem gestrichelten Ausschnitt **D1** der Mehrfachanordnung gemäß **Fig. 11****.** Dort ist zudem veranschaulicht, dass die Tragschiene **1** zum Tragen eines PV-Moduls **2** vorgesehen ist.

Die Rippen **3, 4** sind mit einem Abstand parallel zueinander benachbart und weisen einen für Trapezbleche typischen Querschnitt ähnlich eines Trapezes auf. Weiter zu erkennen ist, dass die Tragschiene **1** im rechten Winkel quer zu den Rippen **3, 4** gerichtet ist und außerdem mit ihrer Unterseite **20** direkt auf den Oberseiten **17, 18** der Rippen **3, 4** aufliegt. Alternativ kann unmittelbar auf den Oberseiten **17, 18** der Rippen **3, 4** eine dünne elastische Schutzunterlage angeordnet sein, auf der wiederum die Tragschiene **1** aufliegt jedoch selbst nicht tragend wirkt. Wesentlich ist, dass die Tragschiene **1** senkrechte Lasten auf die Oberseiten **17, 18** der Rippen **3, 4** abtragen kann. Die Tragschiene **1** ist extrudiert und enthält in an sich bekannter Weise sowohl an der Unterseite **20** als auch an ihrer Oberseite **21** eine beidseitig hinterschnittene Nut **6, 23.** Die obere Nut **23** ist für Klemmeinrichtungen zum Anbringen von PV-Modulen **2** vorgesehen, wie **Fig. 11** zeigt.

Die Befestigung gemäß **Fig. 1** umfasst des Weiteren zwei identische Halteelemente **8, 9,** die an den Rippen **3, 4** befestigt sind. Jedes Halteelement **8, 9** weist hierfür einen rechteckigen Befestigungsabschnitt **10, 11** auf, die flach und plattenförmig sind und den größten Teil der Halteelemente **8, 9** bilden und an denen die Halteelemente **8, 9** jeweils an genau einer schrägen Seite **15a, 16b** der Rippen **3, 4** befestigt sind. Die schrägen Seiten **15a, 16b** sind in statisch günstiger Weise die äußeren beiden Seiten der Rippen **3, 4.**

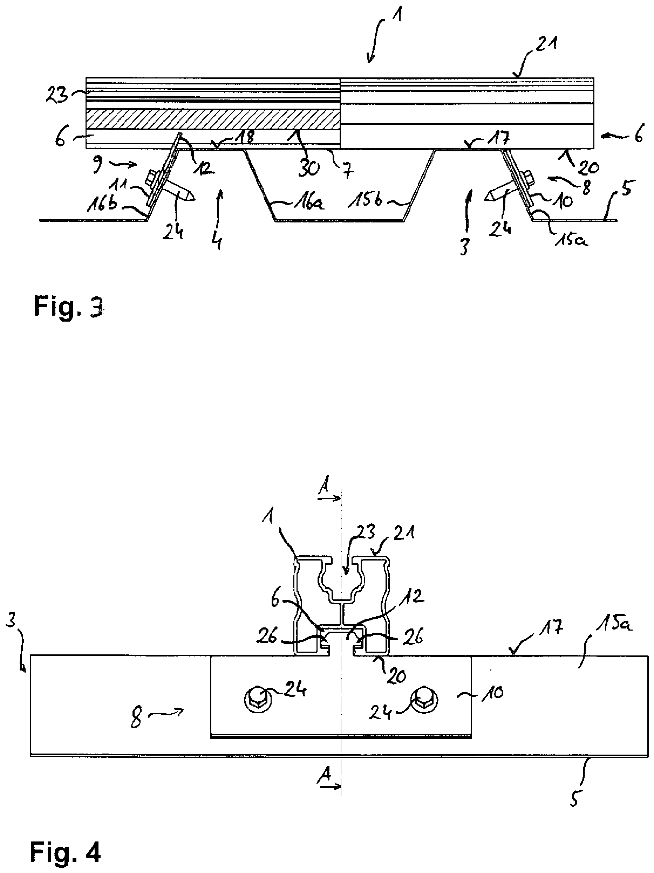

Für die Befestigung sind in den Befestigungsabschnitten **8, 9** je zwei selbstschneidende Schrauben **24** vorgesehen, deren Gewinde hier nicht näher dargestellt ist. Die Schrauben **24** führen durch vorgefertigte Bohrungen **25** in Befestigungsabschnitten **8, 9** sowie durch die schrägen Seite **15a, 16b.** Die Befestigungsabschnitte **8, 9** befinden sich unterhalb des Niveaus der Oberseiten **17, 18.** Wie insbesondere aus **Fig. 4** zu erkennen ist, ist der Befestigungsabschnitt **10** derart gestaltet, dass dieser entlang der schrägen Seite **15a** beidseitig neben der Tragschiene **1** hervorsteht. Ein Monteur kann daher die Schrauben **24** ohne von der Tragschiene **1** behindert zu werden mittels eines Werkzeugs betätigen. Kennzeichnend für die Befestigung gemäß **Fig. 1** ist weiter, dass jedes der Halteelemente **8, 9** einen Eingriffsfortsatz **12** bzw. **13** aufweist, der an dem jeweiligen Befestigungsabschnitt **8, 9** unlösbar angeordnet ist. So sind der Befestigungsabschnitt **10** bzw. **11** und der Eingriffsfortsatz **12** bzw. **13** als einteiliges Blechstück ausgeführt und daher integral miteinander verbunden. Die Eingriffsfortsätze **12, 13** ragen oben mittig von den Befestigungsabschnitten **10, 11** ab, sodass die Halteelemente **8, 9** zentral zur und ganz überwiegend unterhalb der Tragschiene **1** angeordnet sind.

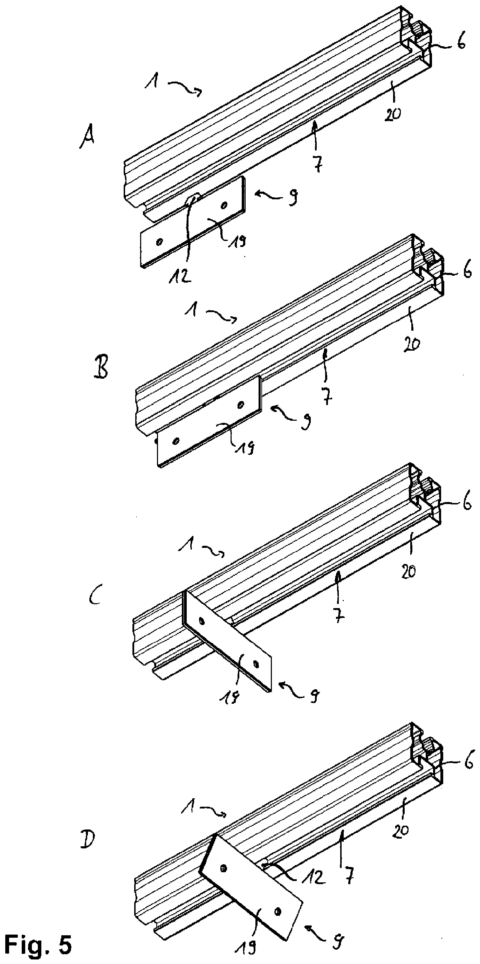

In **Fig. 4** ist außerdem zu erkennen, dass der Eingriffsfortsatz **12** die Nut **6** in einer Eingriffsstellung beidseitig hintergreift. Dazu weißt der Eingriffsfortsatz **12** zwei gegengleich nach außen gerichtete Vorsprünge **26** auf. Die Eingriffsstellung ist quer zur Tragschiene **1** beziehungsweise parallel zur Rippe **3** gerichtet. In einer Losstellung, die gegenüber der Eingriffsstellung um 90° gedreht ist, kann das Halteelement **8** mit dem Eingriffsfortsatz **12** in die Nut **6** durch die Nutöffnung **7** eingesetzt werden, was in **Fig. 5** näher dargestellt ist.

Wesentlich ist weiter, dass die Tragschiene **1** mittels des Eingriffsfortsatzes **8** gegen die Oberseite **17** der Rippe **3** nicht nur niedergehalten, sondern geklemmt ist. Außerdem ist der Eingriffsfortsatz **12** bezüglich der Nutöffnung **7** so gestaltet, dass die Tragschiene **1** in ihrer Querrichtung beidseitig festgelegt ist. Besonders charakteristisch ist, dass nicht nur die Befestigungsabschnitte **10, 11,** sondern auch die Halteelemente **8, 9** als Ganzes entweder nur links oder aber nur rechts an der Rippe **3, 4** angeordnet sind, sich also entweder links oder aber rechts der Mitte der jeweiligen Rippen **3, 4** befinden. Die Begriffe links und rechts sind wie aus **Fig. 1****,** **Fig. 3** und **Fig. 11** zu erkennen ist quer zu den Rippen **3, 4** zu verstehen. Vorzugsweise befinden sich die Halteelemente **8, 9** wie in diesem Ausführungsbeispiel als Ganzes seitlich neben der jeweiligen schräge Seite **15a, 16b** und berühren die Oberseiten **17, 18** im Gegensatz zum Stand der Technik nicht.

**Fig. 5** veranschaulicht in einer Montageabfolge das Zusammenfügen des Halteelements **9** mit der Tragschiene **1** der Befestigung gemäß **Fig. 1****.** Das Halteelement **9** wird ausgehend von einer anfänglichen und zur Tragschiene **1** parallelen Losstellung **A** mit dem Eingriffsfortsatz **12** an einer beliebigen Stelle durch die Nutöffnung **7** in die Nut **6** eingesetzt, sodass es die Stellung **B** erlangt. Anschließend wird das Halteelement **9** um 90° in eine zur Tragschiene **1** quergerichtete Eingriffsstellung **C** gedreht, wo der Eingriffsfortsatz **12** die Nut **6** maximal hintergreift. Schließlich kann das Halteelement **9** in eine der Neigung der schrägen Seite etwa entsprechende Kippstellung **D** gebracht werden. Da der Eingriffsfortsatz **12** in diesem Ausführungsbeispiel bezüglich der Losstellung **A** signifikant schmäler ist als die Nutöffnung **7,** kann das Halteelement **9** nicht nur parallel, sondern auch leicht schräg zur Tragschiene **1** in die Nut **6** einsetzt werden.

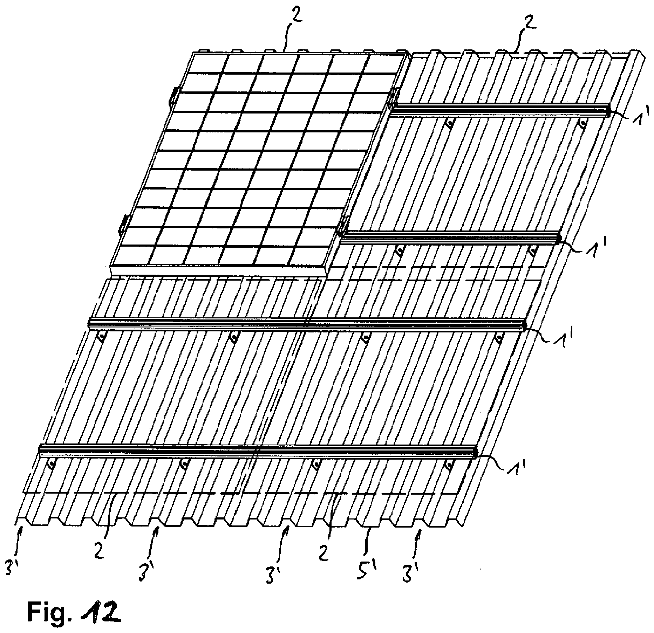

Das Zusammenfügen gemäß **Fig. 5** kann vor oder ebenso nach dem Auflegen der Tragschiene **1** auf die Rippen **3, 4** erfolgen. Falls eine längere Tragschiene vorgesehen ist, die mehr als zwei Rippen quert oder in die mehr als zwei Halteelemente einzusetzen sind, kann es zweckmäßig sein, die Tragschiene zunächst auf die Rippen aufzulegen und die Halteelemente erst danach in die Nut von unten einzusetzen. Mit Blick auf die Anordnung gemäß **Fig. 1** oder **Fig. 12** können somit vorteilhaft bei bereits aufgelegter oder befestigter Tragschiene **1** bzw. **1'** weitere Halteelemente **8, 9** an beliebigen freien schrägen Seite der Rippen nachträglich montiert werden. Somit kann ein Auflegen der Tragschiene **1** bzw. **1'** auf die Rippen **3, 4** zeitlich noch vor dem Einsetzen der Halteelemente **8, 9** und das Einsetzen der Halteelemente **8, 9** zeitlich noch vor dem Befestigen des Befestigungsabschnitts **11** an den schrägen Seiten **15b, 16b** erfolgen. Diese Wahlmöglichkeiten machen die Befestigung im Gegensatz zum Stand der Technik besonders montagefreundlich, vielseitig einsetzbar und fehlertolerant.

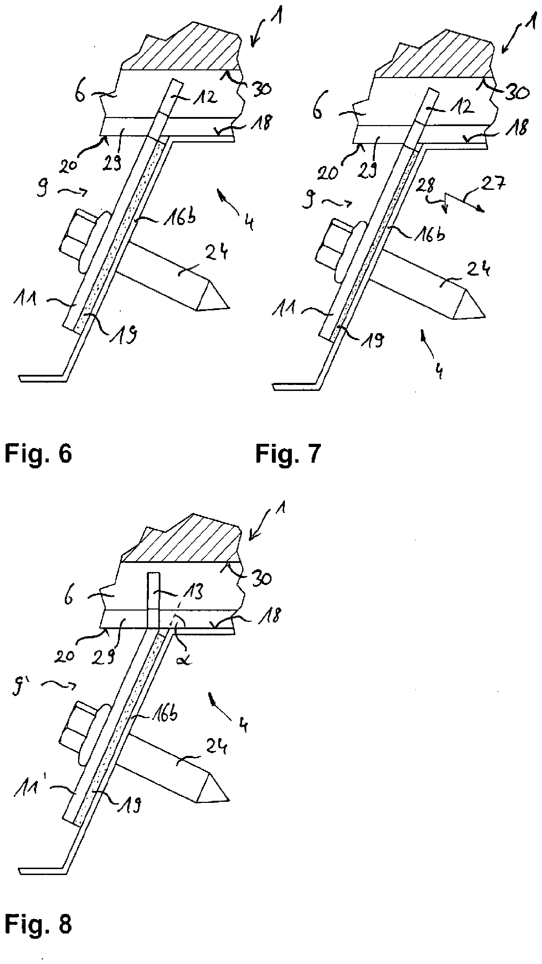

**Fig. 6** und **Fig. 7** zeigen ähnlich wie **Fig. 3** links, jedoch im Detail, dass zwischen dem Befestigungsabschnitt **11** des Halteelements **9** und der schrägen Seite **16b** der Rippe **4** ein elastischer Abstandskörper **19** angeordnet ist. Dieser ist als Schicht ausgeführt, welche den Befestigungsabschnitt **11** parallel von der schrägen Seite **16b** beabstandet. Wesentlich ist, dass der elastische Abstandskörper **19** beim Betätigen der Schrauben **24** komprimiert wird. So ist in einem Endmontagezustand gemäß **Fig. 7** der Abstandskörper **19** schmäler zu erkennen, als in einem Vormontagezustand gemäß **Fig. 6****.** Der elastische Abstandskörper **19** kann gummiartig sein und aus einem Elastomere wie EPDM oder dergleichen bestehen.

Durch diese Komprimierung **27** des Abstandskörpers **26** verringert sich der Abstand zwischen dem Befestigungselement **11** und der schrägen Seite **16b,** wodurch das Halteelement **9** aufgrund der Neigung der schrägen Seite **16b** eine kaum wahrnehmbar Bewegungskomponente **28** nach unten erfährt. Dies bewirkt jedoch, dass das Halteelement **9** mit dem Eingriffsfortsatz **12** die Tragschiene **1** zunehmend gegen die Oberseite **18** der Rippe **4** klemmt. Die Komprimierung **27** und die Bewegungskomponente **28** sind in **Fig. 7** zur Veranschaulichung etwa 10-fach vergrößert dargestellt. Wie an dem Pfeil **28** zu erkennen ist, bedeutet nach unten in diesem Zusammenhang eine Richtung nach unten, die senkrecht zur Oberseite **18** ist

Der Abstandskörper **26** wirkt zugleich als Dichtung gegen Regenwasser, welches andernfalls in die Rippe **4** durch nicht näher ersichtliche Öffnungen in der schrägen Seite **16b** für die Schrauben **24** eindringen könnte. Zur Vereinfachung der Montage ist der Abstandskörper **26** am Befestigungsabschnitt **11** bereits vorgefertigt aufgeklebt, beispielsweise mittels Klebstoff oder doppelseitigem Klebeband. Alternativ oder ergänzend kann das Abstandsmittel unter Verwendung von Haltenoppen befestigt sein, die in die Öffnungen 25 eingedrückt sind.

**Fig. 8** zeigt ein weiteres Ausführungsbeispiel eines Halteelements **9',** das noch nicht endmontiert ist. Der Unterschied zu den vorbeschriebenen Halteelementen besteht darin, dass dessen Eingriffsfortsatz **13** zum Befestigungsabschnitt **11'** dergestalt winklig angestellt ist, dass der Eingriffsfortsatz **13** steiler gerichtet ist, als die schräge Seite **16b** der Rippe **4.** Das heißt, ein Winkel zwischen dem Eingriffsfortsatz **13** und der Oberseite **18** der Rippe **4** ist einem Rechten Winkel näher als ein entsprechender Winkel α zwischen einer gedachten geraden Verlängerung der schrägen Seite **16b** und der Oberseite **18** der Rippe **4.** In diesem Ausführungsbeispiel steht der Eingriffsfortsatz **13** sogar senkrecht zur der Oberseite **18** der Rippe **4** und hintergreift demzufolge die Ränder **29** der Nut **6** senkrecht.

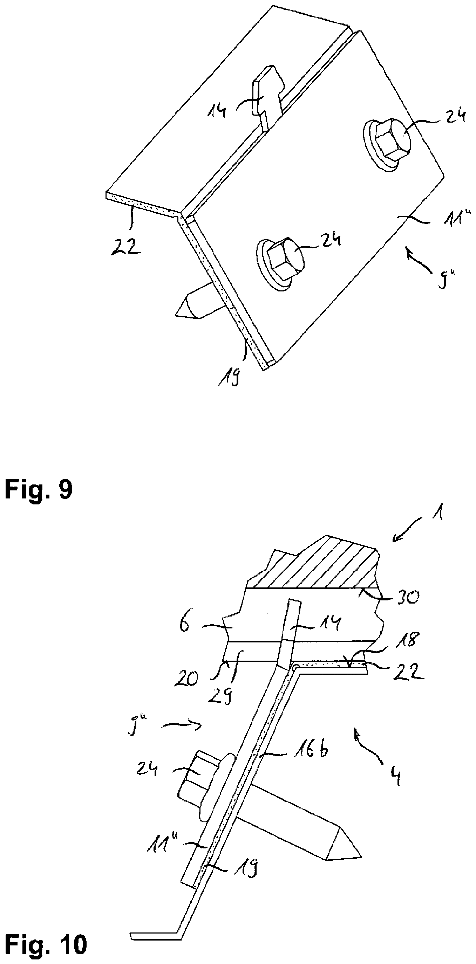

**Fig. 9** zeigt ein weiteres Ausführungsbeispiel eines Halteelements **9".** Ein Unterschied zu den vorbeschriebenen Halteelementen **9** und **9'** besteht darin, dass das elastische Abstandsmittel **19** einen integralen Fortsatz **22** aufweist, der dafür vorgesehen ist, zwischen der Oberseite **18** der Rippe **4** und der Unterseite **20** der Tragschiene **1** angeordnet zu werden. So zeigt **Fig. 10** das Haltemittel **9"** in einem endmontierten Zustand, in welchem die Tragschiene **1** gegen die Oberseite **18** geklemmt ist und der Fortsatz **22** zwischen diesen angeordnet ist. Der Fortsatz **22** wirkt einsatzgemäß als Schutzauflage und schützt die Oberseite **18** vor einem Abrieb und kann zudem den Kraftschluss quer zur Rippe **4** erhöhen. Durch Vorsehen des Fortsatzes **22** am Abstandsmittel **19** kann auf gesonderte Schutzmaßnahmen verzichtet werden, wie beispielsweise ein vorheriges Aufbringen einer Schutzauflage auf der Oberseite **18** oder an der Unterseite **20.** Ein weiterer Unterschied zu den vorherigen Halteelementen **9** und **9'** besteht darin, dass der Eingriffsfortsatz **14** bezüglich der Oberseite **18** weniger als 90° jedoch steiler als die schräge Seite **16b** winklig angestellt ist.

**Fig. 11** zeigt eine Mehrfachanordnung mit insgesamt zwölf identischen Befestigungen gemäß **Fig. 1****,** wobei eine gemeinsame Trapezblechfläche **5'** mit einer Vielzahl trapezförmiger Rippen vorgesehen ist. Die Trapezblechfläche **5'** kann wie dargestellt aus einem einzigen Trapezblech bestehen oder aber aus mehreren solchen zusammengesetzt sein. Die Tragschienen **1** sind alle quer zu den Rippen gerichtet und in einem für die Anbringung rechteckiger PV-Module **2** geeigneten Raster angeordnet. Auf den Tragschienen **1** sind vier solcher PV-Module **2** angeordnet, von denen drei lediglich schematisch angedeutet sind.

Da die Tragschienen **1** möglichst kurz sein sollen aber der Abstand der Rippen und das Format der PV-Module **2** für gewöhnlich nicht aufeinander abgestimmt sind, ist es zweckmäßig, wenn die Tragschienen **1** zwei der Rippen quert oder bei größeren Rippenabständen gegebenenfalls drei. In diesem Ausführungsbeispiel ist es ausreichend, dass die Tragschienen **1** lediglich zwei Rippen **3, 4** quert. Demgemäß führen die Tragschienen **1** nicht unter den PV-Modulen **2** durchgängig hindurch, sondern enden in materialsparender Art jeweils unter den PV-Modulen **2.** Der gestrichelt markierte Ausschnitt **D1** entspricht im Übrigen der Befestigung gemäß **Fig. 1****.**

Für die Anbringung der PV-Module **2** kreuzen die Tragschienen **1** die zu den Rippen parallelen Kanten der PV-Module **2,** wobei diese Kanten in statisch günstiger Weise die Längskanten der PV-Module **2** sind. Mit diesen Längskanten liegen die PV-Module **2** links und rechts auf jeweils zwei der Tragschienen **1** auf. Dabei ist wesentlich, dass in Querrichtung der Rippen benachbarte PV-Module **2** mit ihren benachbarten Längskanten auf jeweils zwei der Tragschienen **1** aufliegen und angebracht sind. Wie bei dem PV-Modul **2** rechts oben gezeigt, können die PV-Module **2** dazu in herkömmlicher Weise gegen die Tragschienen **1** geklemmt sein. Die benachbarten Längskanten werden vorzugsweise gemeinsam mittels sogenannter Mittelklemmen befestigt, die am Rand hingegen einzeln mit sogenannten Endklemmen.

**Fig. 12** veranschaulicht schließlich, dass vier lange Tragschienen **1'** die PV-Module **2** ebenso auch herkömmlich in einer Reihe tragen und dazu unter den PV-Modulen **2** hindurchführen und entsprechend viele Rippen der Trapezblechfläche **5'** queren können. Die Tragschienen **1'** sind jeweils mit vier Halteelementen **8** gemäß **Fig. 1** in regelmäßigen Abständen gegen die Oberseiten der Rippen **3'** geklemmt.

## Patentansprüche

1. Befestigung einer Tragschiene **(1)** für ein Photovoltaik-Modul an einer trapezförmigen Rippe **(3)** eines Trapezblechs **(5),** mit der Tragschiene **(1),** wobei die Tragschiene **(1)** eine hinterschnittene Nut **(6)** mit einer Nutöffnung **(7)** enthält und die Tragschiene **(1)** quer zu der Rippe **(3)** gerichtet ist, und mit mindestens einem Halteelement **(8),** wobei das Haltelement **(8)** einen Befestigungsabschnitt **(10)** aufweist, der an einer schrägen Seite **(15a)** der Rippe **(3)** befestigt ist, **dadurch gekennzeichnet, dass** das Halteelement **(8)** entweder links oder rechts an der Rippe **(3)** angeordnet ist, und das Halteelement **(8)** einen Eingriffsfortsatz **(12)** aufweist, der an dem Befestigungsabschnitt **(10)** unlösbar angeordnet ist, wobei der Eingriffsfortsatz **(12)** die Nut **(6)** in einer Eingriffsstellung **(C)** hintergreift und in einer dazu gedrehten Losstellung **(A)** durch die Nutöffnung **(7)** in die Nut **(6)** einsetzbar ist, und die Tragschiene **(1)** mittels des Eingriffsfortsatzes **(12)** gegen die Oberseite **(17)** der Rippe **(3)** niedergehalten ist, und wobei die Nut **(6)** beidseitig hinterschnitten ist und der Eingriffsfortsatz **(12)** die Nut **(6)** beidseitig hintergreift, wofür der Eingriffsfortsatz **(12)** zwei gegengleich nach außen gerichtete Vorsprünge **(26)** aufweist, wobei der Eingriffsfortsatz **(12)** und der Befestigungsabschnitt **(10)** integral miteinander verbunden sind und/oder einteilig aus einem Stück Blech oder Kunststoff bestehen.

2. Befestigung nach einem der vorhergehenden Ansprüche, **dadurch gekennzeichnet, dass** der Eingriffsfortsatz **(13, 14)** zum Befestigungsabschnitt **(11', 11")** dergestalt winklig angestellt ist, dass der Eingriffsfortsatz **(13,14)** steiler gerichtet ist als die schräge Seite **(16b)** der Rippe **(4).**

3. Befestigung nach einem der vorhergehenden Ansprüche, **dadurch gekennzeichnet, dass** der Befestigungsabschnitt **(10)** entlang der Rippe **(3)** beidseitig neben der Tragschiene **(1)** hervorsteht.

4. Befestigung nach einem der vorhergehenden Ansprüche, **dadurch gekennzeichnet, dass** zwischen dem Befestigungsabschnitt **(11, 11', 11")** und der schrägen Seite **(16b)** der Rippe ein elastisches und/oder plastisches Abstandsmittel **(19)** angeordnet ist.

5. Befestigung nach dem vorhergehenden Anspruch, **dadurch gekennzeichnet, dass** das elastisches und/oder plastisches Abstandsmittel **(19)** am Befestigungsabschnitt **(11, 11', 11")** vorgefertigt befestigt ist.

6. Befestigung nach Anspruch 4, **dadurch gekennzeichnet, dass** das elastische und/oder plastische Abstandsmittel **(19)** einen Fortsatz **(22)** aufweist, der zwischen der Oberseite **(18)** der Rippe **(4)** und der Tragschiene **(1)** angeordnet ist.

7. Befestigung nach einem der vorhergehenden Ansprüche, **dadurch gekennzeichnet, dass** das Trapezblech **(5)** weitere trapezförmige Rippen **(4)** aufweist und die Tragschiene **(1)** mehrere der Rippen **(3, 4)** quert und mindestens ein weiteres solches Halteelement **(9)** vorgesehen ist, mit dem die Tragschiene **(1)** gegen die Oberseite **(18)** von mindestens einer der weiteren Rippen **(4)** niedergehalten ist.

8. Befestigung nach dem vorhergehenden Anspruch, **dadurch gekennzeichnet, dass** die Tragschiene genau drei oder zwei der Rippen **(3, 4)** quert und genau ein weiteres solches Halteelement **(9)** vorgesehen ist, mit dem die Tragschiene **(1)** gegen die Oberseite **(18)** von genau einer weiteren der drei oder zwei Rippen **(4)** niedergehalten ist.

9. Befestigung nach dem vorhergehenden Anspruch, **dadurch gekennzeichnet, dass** die Halteelemente **(8, 9)** an den zwei äußeren schrägen Seiten **(15a, 16b)** der drei oder zwei Rippen **(3, 4)** befestigt sind.

10. Montageverfahren für eine Befestigung nach Anspruch 4, **dadurch gekennzeichnet, dass** während der Befestigung des Befestigungsabschnitts **(11)** an der schrägen Seite **(16b)** das elastische und/oder plastische Abstandsmittel **(19)** komprimiert wird und das Halteelement **(9)** eine Bewegungskomponente **(28)** nach unten erfährt und das Halteelement **(9)** mit dem Eingriffsfortsatz **(12)** die Tragschiene **(1)** zunehmend gegen die Oberseite **(17)** der Rippe **(4)** klemmt.

11. Anordnung mit einer Befestigung nach einem der vorhergehenden Ansprüche 1 bis 9, **dadurch gekennzeichnet, dass** eine weitere solche Befestigung vorgesehen Ist oder drei weitere solche Befestigungen vorgesehen sind, wobei auf den Tragschienen **(1)** der Befestigungen ein Photovoltaik-Modul **(2)** angebracht Ist.

## Claims

1. A fastening of a support rail (1) for a photovoltaic module to a trapezoidal rib (3) of a trapezoidal sheet (5), comprising the support rail, wherein the support rail (1) comprises an undercut groove (6) with a groove opening (7) and the support rail (1) is positioned transversely to the rib (3), and further comprising at least one retaining element (8), the retaining element (8) having a fastening section (10) which is fastened to a slanted side (15a) of the rib (3), **characterized in that** the retaining element (8) is arranged either to a left or to a right of the rib (3), and the retaining element (8) has an engaging extension (12) which is non-detachably arranged on the fastening section (10), wherein the engaging extension (12) engages behind the groove (6) in an engaging position (C) and is configured to be insertable through the groove opening (7) into the groove (6) in a loose position (A) rotated relative to the engaging position (C), and the support rail (1) is held down against the upper side (17) of the rib (3) by means of the engaging extension (12), and wherein the groove (6) is undercut on both sides and the engaging extension (12) engages behind the groove (6) on both sides, the engaging extension (12) being provided with two protrusions (26) arranged in opposing outward directions for this purpose, wherein the engaging extension (12) and the fastening section (10) are integrally connected to each other and/or consist of a one-part unit made of a piece of sheet metal or plastic.

2. The fastening according to one of the preceding claims, **characterized in that** the engaging extension (13, 14) is formed at an angle to the fastening section (11', 11") such that the engaging extension (13, 14) is steeper than the slanted side (16b) of the rib (4).

3. The fastening according to one of the preceding claims, **characterized in that** the fastening section (10) protrudes along the rib (3) on both sides beside the support rail (1).

4. The fastening according to one of the preceding claims, **characterized in that** an elastic and/or plastic spacer (19) is arranged between the fastening section (11, 11', 11") and the slanted side (16b) of the rib.

5. The fastening according to one of the preceding claims, **characterized in that** the elastic and/or plastic spacer (19) is fastened to the fastening section (11, 11', 11") in a prefabricated manner.

6. The fastening according to claim 4, **characterized in that** the elastic and/or plastic spacer (19) comprises an extension (22) arranged between the upper side (18) of the rib (4) and the support rail (1).

7. The fastening according to one of the preceding claims, **characterized in that** the trapezoidal sheet (5) includes additional trapezoidal ribs (4) and that the support rail (1) crosses a plurality of the ribs (3, 4), and at least one additional retaining element (9) is provided, which is configured to hold the support rail (1) down against the upper side (18) of at least one of the additional ribs (4).

8. The fastening according to one of the preceding claims, **characterized in that** the support rail crosses exactly three or two of the ribs (3, 4), and exactly one additional retaining element (9) is provided, which is configured to hold the support rail (1) down against the upper side (18) of exactly one other of the three or two ribs (4).

9. The fastening according to one of the preceding claims, **characterized in that** the retaining elements (8, 9) are fastened to the two outer slanted sides (15a, 16b) of the three or two ribs (3, 4).

10. A method of assembling a fastening according to claim 4, **characterized in that** during fastening of the fastening section (11) to the slanted side (16b) the elastic and/or plastic spacer (19) is compressed and the retaining element (9) undergoes a movement component in a downward direction and the retaining element (9) increasingly clamps the support rail (1) against the upper side (17) of the rib (4) via the engaging extension (12).

11. An arrangement comprising a fastening according to one of the preceding claims 1 to 9, **characterized in that** a further fastening of this type is provided or three further fastenings of this type are provided, the support rails (1) of the fastenings having attached thereto a photovoltaic module (2).

## Revendications

1. Fixation d'un rail porteur (1) pour un module photovoltaïque sur une nervure trapézoïdale (3) d'une tôle trapézoïdale (5), comprenant le rail porteur, le rail porteur (1) contenant une rainure en contre-dépouille (6) avec une ouverture de rainure (7) et le rail porteur (1) étant dirigé transversalement à la nervure (3), et avec au moins un élément de maintien (8), l'élément de maintien (8) présentant une partie de fixation (10) qui est fixée sur un côté incliné (15a) de la nervure (3),
**caractérisée en ce que** l'élément de maintien (8) est disposé à gauche ou à droite sur la nervure (3), et **en ce que** l'élément de maintien (8) présente un appendice d'engagement (12) disposé de manière inamovible sur la partie de fixation (10), lequel appendice d'engagement (12) venant en prise derrière la rainure (6), dans une position d'engagement (C), et pouvant être insérée dans la rainure (6) à travers l'ouverture de rainure (7), dans une position détachée (A) tournée par rapport à la position d'engagement (C), et le rail porteur (1) étant maintenu contre le côté supérieur (17) de la nervure (3) au moyen de l'appendice d'engagement (12), et la rainure (6) présentant une contre-dépouille des deux côtés et l'appendice d'engagement (12) venant en prise derrière la rainure (6) des deux côtés, pour ce faire l'appendice d'engagement (12) présentant deux saillies (26) dirigées vers l'extérieur dans des directions opposées, l'appendice d'engagement (12) et la partie de fixation (10) étant reliés l'un à l'autre d'un seul tenant et/ou étant constitués d'une seule pièce en tôle ou en matière plastique.

2. Fixation selon l'une des revendications précédentes, **caractérisée en ce que** l'appendice d'engagement (13, 14) est disposé selon un angle par rapport à la partie de fixation (11', 11"), de telle sorte que l'appendice d'engagement (13, 14) présente une pente plus raide que le côté incliné (16b) de la nervure (4).

3. Fixation selon l'une des revendications précédentes, **caractérisée en ce que** la partie de fixation (10) dépasse des deux côtés près du rail porteur (1) le long de la nervure (3).

4. Fixation selon l'une des revendications précédentes, **caractérisée en ce qu'**un moyen d'écartement élastique et/ou plastique (19) est disposé entre la partie de fixation (11, 11', 11") et le côté incliné (16b) de la nervure.

5. Fixation selon la revendication précédente, **caractérisée en ce que** le moyen d'écartement élastique et/ou plastique (19) est fixé de manière préfabriquée à la partie de fixation (11, 11', 11").

6. Fixation selon la revendication 4, **caractérisée en ce que** le moyen d'écartement élastique et/ou plastique (19) présente un prolongement (22) qui est disposé entre le côté supérieur (18) de la nervure (4) et le rail porteur (1).

7. Fixation selon l'une des revendications précédentes, **caractérisée en ce que** la tôle trapézoïdale (5) présente d'autres nervures trapézoïdales (4) et le rail porteur (1) croise plusieurs des nervures (3, 4) et au moins un autre élément de maintien (9) de ce type est prévu, avec lequel le rail porteur (1) est maintenu contre le côté supérieur (18) d'au moins une des autres nervures (4).

8. Fixation selon la revendication précédente, **caractérisée en ce que** le rail porteur croise exactement trois ou deux des nervures (3, 4) et qu'il est prévu exactement un autre élément de maintien (9) de ce type, avec lequel le rail porteur (1) est maintenu contre le côté supérieur (18) d'exactement une autre des trois ou deux nervures (4).

9. Fixation selon la revendication précédente, **caractérisée en ce que** les éléments de maintien (8, 9) sont fixés sur les deux côtés extérieurs inclinés (15a, 16b) des trois ou deux nervures (3, 4).

10. Procédé de montage pour une fixation selon la revendication 4, **caractérisé en ce que** pendant la fixation de la partie de fixation (11) sur le côté incliné (16b), le moyen d'écartement élastique et/ou plastique (19) est comprimé et l'élément de maintien (9) subit une composante de mouvement (28) vers le bas, l'élément de maintien (9) serrant de plus en plus le rail porteur (1) contre le côté supérieur (17) de la nervure (4) avec l'appendice d'engagement (12).

11. Agencement comprenant une fixation selon l'une des revendications 1 à 9 précédentes, **caractérisé en ce qu'**une autre fixation de ce type est prévue ou trois autres fixations de ce type sont prévues, un module photovoltaïque (2) étant monté sur les rails porteurs (1) des fixations.
